# EUROPEAN PATENT SPECIFICATION

(11) **EP 0 454 201 B1**
(45) Date of publication and mention of the grant of the patent: **30.10.1996**
(21) Application number: 91200798.6
(22) Date of filing: 05.04.1991
(51) Int. Cl.: H01L 29/74

(54) **A semiconductor device comprising a thyristor**
Halbleiteranordnung mit einem Thyristor
Dispositif semi-conducteur comprenant un thyristor

(30) Priority: 09.04.1990 GB 9008020
(43) Date of publication of application: 30.10.1991
(73) Proprietor: PHILIPS ELECTRONICS UK LIMITED, Croydon CR9 3QR (GB); Philips Electronics N.V., 5621 BA Eindhoven (NL)
(72) Inventor: Gough, Paul Arthur, Redhill, Surrey RH1 5HA (GB)
(74) Representative: Stevens, Brian Thomas

(56) References cited:
- EP-A- 487 869
- EP-A- 0 106 059
- EP-A- 0 159 663

## Description

This invention relates to a semiconductor device comprising a thyristor and especially, but not exclusively, to a semiconductor device comprising a so-called MOS-gated thyristor.

Semiconductor devices are known which comprise a semiconductor body having formed therein a thyristor having a first region of one conductivity type provided with a first main electrode, a second region of the opposite conductivity type forming a first pn junction with the first region, a third region of the one conductivity type forming a second pn junction with the second region and provided with a gate electrode, and a fourth region of the opposite conductivity type forming a third pn junction with the third region and having an electrical connection to a second main electrode.

In particular, semiconductor devices are known in which the gate electrode is in the form of an insulated gate overlying a conduction channel area of the third region for controlling a conductive path between the second region and the fourth region to enable the flow of charge carriers of the opposite conductivity type from the fourth region to the second region to trigger latching and so initiate thyristor action within the device. Such a MOS-gated thyristor is described at page 411 of a review entitled 'Evolution of MOS-bipolar Power Semiconductor Technology by B. Jayant Baliga published in Proceedings of the IEEE Vol. 76, No. 4, April, 1988.

The aforementioned paper also describes at pages 415 to 416 a so-called MOS turn-off thyristor which differs from the simple MOS-gated thyristor in that it is capable of being both turned-on and turned-off by a signal applied to a MOS gate. The MOS turn-off thyristor consists of an insulated gate field effect transistor (MOST) integrated into the thyristor structure in such a manner that the emitter-base junction of the upper transistor can be short-circuited by the application of a gate voltage to the MOST. In the absence of the gate voltage, the device can be switched on either in the same manner as a conventional thyristor or by using a MOS gate in the same manner as for a MOS-gated thyristor. Thus, as shown in Figure 15 of the aforementioned paper, the MOS turn-off thyristor has a fifth region of the one conductivity type formed within and shorted to the fourth region and the contiguous insulated gate overlies channel areas of the fourth and third regions. In order to achieve turn-off of the thyristor, the MOST defined between the fifth and third regions is turned-on by an appropriate voltage applied to the insulated gate so that charge carriers of the one conductivity type entering the third region have an alternate path to the second main electrode by-passing the pn junction between the fourth and third regions. However to achieve such forced turn-off, the resistance of the current path for the charge carriers of the one conductivity type must be so low that, when all such current is diverted via the MOST between the fifth and third regions, the forward biasing of the third pn junction is below 0.7 volts and so insufficient to maintain electron injection and transistor action. Although this condition may be quite readily achieved for relatively high current densities where the charge carriers of the one conductivity type are electrons, it is more of a problem where the charge carriers are less mobile holes.

EP-A-0 159 663 describes a semiconductor device comprising a semiconductor body having formed therein a thyristor having first and second main electrodes, a first region of one conductivity type provided within the first main electrode, a second region of the opposite conductivity type forming a first pn junction with the first region, a third region of the one conductivity type forming a second pn junction with the second region and a fourth region of the opposite conductivity type forming a third pn junction with the third region. An insulated gate extends within a V-groove formed within the surface of the semiconductor body to overlie a first conduction channel area. A fifth region of the one conductivity type forms a fourth pn junction with the fourth region and a sixth more highly doped region of the opposite conductivity type is provided in electrical connection with the second main electrode. The sixth region forms a pn junction with the fifth region and also contacts the fourth region to enable good ohmic contact between the fourth region and the second main electrode.

It is an aim of the present invention to provide a semiconductor device comprising a thyristor in which the controllable current capability of the device is improved.

According to the present invention, there is provided a semiconductor device comprising a semiconductor body having formed therein a thyristor having first and second main electrodes, a first region of one conductivity type provided with the first main electrode, a second region of the opposite conductivity type forming a first pn junction with the first region, a third region of the one conductivity type forming a second pn junction with the second region, a fourth region of the opposite conductivity type forming a third pn junction with the third region, the third region being provided with a insulated gate electrode overlying a first conduction channel area, a fifth region of the one conductivity type forming a fourth pn junction with the fourth region, and a sixth region of the opposite conductivity type in electrical connection with the second main electrode forming a fifth pn junction with the fifth region, characterised in that the sixth region is separated from the fourth region by the fifth region, the fifth region is coupled to an electrode and in that the insulated gate overlies adjacent first, second and third conduction channel areas of the third, fourth and fifth regions, respectively, the adjacent first, second and third conduction channels areas providing an opposite conductivity type charge carrier conductive path between the sixth and second regions for initiating thyristor action to turn on the device when a voltage of a given polarity is applied to the insulated gate electrode and a one conductivity type charge carrier conductive path to the electrode via the fifth region along which charge carriers of the one conductivity type are extracted and the flow of opposite conductivity type charge carriers is inhibited to facilitate turn-off of the device when a voltage of the opposite polarity to the given polarity is applied to the insulated gate electrode.

Thus, in a semiconductor device in accordance with the invention, electrical connection to the fourth region (the cathode in the case of an npnp thyristor) is provided by an integrated insulated gate field effect transistor (MOST) effectively in series with the fourth region which provides a gateable conductive path for the flow of charge carriers of the opposite conductivity type to the fourth region so enabling the flow of such charge carriers to be stemmed by application of an appropriate gate voltage during turn-off of the thyristor to improve the controllable current capability of the thyristor. In addition, the control over the flow of the charge carriers of the opposite conductivity type provided by the MOS in series with the fourth region should reduce turn-off times in comparison to the previously described MOS-controller thyristors described above.

The insulated gate may be defined on the s ide walls of a groove extending into the semiconductor body. In particular, the groove may be in the form of a trench having its side walls covered by an insulating layer and being filled with electrically conductive material forming the gate electrode. The use of a groove or trench technology rather than a planar technology to form the insulated gates reduces the amount of surface area required and should provide better current handling capabilities.

In a modified embodiment of a device in accordance with the invention, in one or more areas of the semiconductor body, the third, fourth, fifth and sixth regions are replaced by a further region of the one conductivity with the insulated gate overlying a conduction channel area of the further region so that the further region defines with the first and second regions a three layer structure arranged in parallel with the structure defined by the first to sixth regions between the first and second main electrodes so that the further region provides a path for extraction of charge carriers of the one conductivity during turn-off of the thyristor. Such a structure enables an increase in the turn-off speed of the device and should, by diverting the current flow of the one conductivity type, also increase the maximum controllable current.

The first and second main electrodes may be provided on opposed surfaces of the semiconductor body so forming a vertical device, that is a device which the main current path is between the two opposed major surfaces of the semiconductor body.

The fifth region may be electrically connected to the second main electrode so as to form a three terminal device. Alternatively, a separate further electrode may be provided for the fifth region which because of the independent control of the voltages applied to the second and further electrodes should further reduce the possibility of transistor action continuing during turn-off of the thyristor.

Embodiments of the invention will now be described, by way of example, with reference to the accompanying drawings, in which:
Figure 1 is a schematic cross-sectional view of a first embodiment of a semiconductor device in accordance with the invention;
Figure 2 is a schematic cross-sectional view of a second embodiment of a semiconductor device in accordance with the invention; and
Figure 3 is a schematic cross-sectional view of a modified embodiment of a semiconductor device in accordance with the invention.

It should, of course, be understood that the Figures are merely schematic and that, in particular, various dimensions such as the thicknesses of layers or regions may have been exaggerated in the interests of clarity.

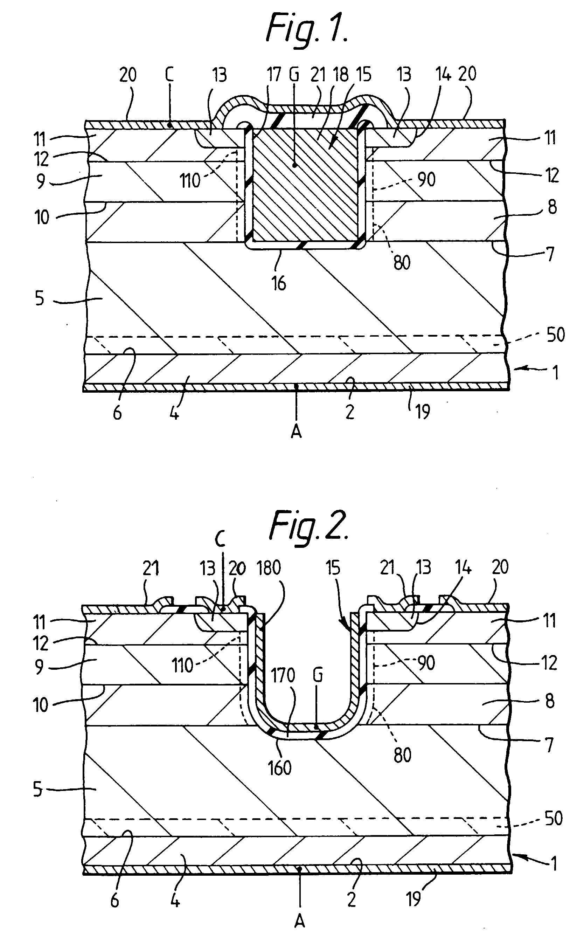

Referring now to the drawings, for example Figure 1, there is illustrated a semiconductor device comprising a semiconductor body 1 having formed therein a thyristor having first and second main electrodes A and C, a first region 4 of one conductivity type provided with the first main electrode A, a second region 5 of the opposite conductivity type forming a first pn junction 6 with the first region 4, a third region 8 of the one conductivity type forming a second pn junction 7 with the second region 5, a fourth region 9 of the opposite conductivity type forming a third pn junction 10 with the third region 8, the third region 8 being provided with a insulated gate electrode G overlying a first conduction channel area 80, a fifth region 11 of the one conductivity type forming a fourth pn junction 12 with the fourth region 9, and a sixth region 13 of the opposite conductivity type in electrical connection with the second main electrode C forming a fifth pn junction 14 with the fifth region 11.

In accordance with the invention the sixth region 13 is separated from the fourth region 9 by the fifth region 11, the fifth region 11 is coupled to an electrode 21, C and the insulated gate G, 15 overlies adjacent first 80, second 90 and third 110 conduction channel areas of the third 8, fourth 9 and fifth 11 regions, respectively, the adjacent first 80, second 90 and third 110 conduction channels areas providing an opposite conductivity type charge carrier conductive path between the sixth 13 and second 5 regions for initiating thyristor action to turn on the device when a voltage of a given polarity is applied to the insulated gate electrode G, 15 and a one conductivity type charge carrier conductive path to the electrode 21,C via the fifth region along which charge carriers of the one conductivity type are extracted and the flow of opposite conductivity type charge carriers is inhibited to facilitate turn-off of the device when a voltage of the opposite polarity to the given polarity is applied to the insulated gate electrode G, 15.

Thus, in a semiconductor device in accordance with the invention, an insulated gate field effect transistor (MOST) provided by the fourth, fifth and sixth regions 9,11 and 13 and the insulated gate 15 is provided in series with the fourth region 9 of the thyristor to provide a gateable conductive path via the conduction channel area 110 for the flow of charge carriers of the opposite conductivity type to the fourth region 9 so enabling this flow to be stemmed by application of an appropriate gate voltage during turn-off of the thyristor to allow a greater controllable current capability and in addition to enable the turn-off time of the device to be reduced.

Referring now specifically to Figure 1 there is illustrated an npnp thyristor having a MOS-gated cathode in accordance with the invention.

Thus, in the example shown in Figure 1, the first or anode region 4 is provided as a monocrystalline silicon substrate doped with impurities of the one conductivity type, in this example boron ions, to provide a resistance of 3 typically 0.01 ohm cm. The second or n-base region 5 is then provided on the first region 4 as a relatively lowly doped epitaxial layer of silicon doped with impurities of the opposite conductivity type, in this case n conductivity type, for example arsenic ions, to a dopant concentration of typically 10¹⁴ atom cm⁻³. If desired a more highly n-conductivity type doped buffer layer 50 (shown in phantom lines in Figure 1) may be provided between the first and second regions 4 and 5 to moderate the hole current from the relatively highly doped first or anode region 4. The dopant concentration and thickness of the epitaxial layer deposited to form the second region 5 will depend on the desired characteristics of the device but may typically be 100µm (micrometres) for a 1000 volt device. The third region 8 may be provided as an epitaxial layer doped with impurities of the one conductivity type, p type in this example, or alternatively may be formed by implantation and/or diffusion of impurities into the second region 5.

The third region, in this example the p-base region 8, the fourth or cathode region 9, and the fifth region 11 may all be formed either by epitaxial growth of appropriately doped layers of silicon or by implantation and/or diffusion of the appropriate impurities into the second region 5. Typically, for a 1000 volt device, the p-base region may have a thickness of about 3µm and a dopant concentration of about 10¹⁶ atoms cm⁻³ whilst the cathode region 9 may have a thickness of about 1µm and a dopant concentration of about 10¹⁶ atom cm⁻³. The fifth region 11 may be about 2µm thick and have a dopant concentration of about 3 x 10¹⁶ atoms cm⁻³.

In this example, the sixth region 13 is then formed as a planar region within the fifth region 11 by introducing impurities of the opposite conductivity type, n conductivity type in this example, through an appropriate mask (not shown) in conventional manner. Typically, the sixth region 13 may have a depth of about 0.5 to 1µm.

The thyristor shown in Figure 1 is a MOS-gated thyristor so that the gate electrode G of the third region 7 comprises an insulated gate and in the example being described this insulated gate is contiguous with the insulated gate 15 of the MOS-gated cathode.

In the example shown in Figure 1, the insulated gate 15 is defined by first etching, using conventional techniques, a trench 16 through the sixth, fifth, fourth and third regions 13,11,9,7 and slightly into the second region 5. The depth of the trench should, as is known in the art, be carefully controlled so as to ensure that the trench 16 extends completely through the third region 8 but does not extend so far into the second region 5 as to adversely effect the desired breakdown voltage of the device. For the dimensions given above for the regions 8,9 and 11, the trench 16 will be about 6µm deep. After usual cleaning procedures, a thin insulating layer 17 is thermally grown by conventional techniques on the side walls of the trench and with the mask used during definition of the trench still in place, electrically conductive material, in this example doped polycrystalline silicon, is deposited into the trench to form an electrically conductive plug 18 providing the gate electrode G of the third region 8 and also the insulated gate 15 overlying the conduction channel area 110 of the fifth region 11. A layer of insulating material, for example silicon dioxide, is then deposited and patterned using conventional photolithographic and etching techniques to define a capping oxide layer 21 covering the electrically conductive plug 18.

Conventional metallisation 19,20, for example aluminium, is then deposited onto the opposed surfaces 2 and 3 of the semiconductor body 1 to define the first (anode) and second (cathode) main electrodes A and C. Although not shown in Figure 1, contact is made to the gate G at the periphery of the device I.

Thus, in the example shown in Figure 1, the fifth region 11 is shorted via the cathode metallisation to the second (cathode) main electrode C.

Generally, the device will have a cellular structure with the trench 16 forming, when viewed in plan (that is looking down onto the surface of the fifth region 11), a grid or mesh structure. Thus, for example, the trench 16 may form a rectangular grid pattern or possibly a hexagonal grid pattern. Figure 1 thus shows a cross-section through one strip like section of the grid - like trench 16.

In operation of the thyristor shown in Figure 1, the device is turned-on by applying an appropriate positive gate voltage +Ve to the gate electrode G. The positive gate voltage induces an n conductivity type inversion channel in the conduction channel areas 110 and 80 along the edge of the trench 16 allowing the flow of electrons into the second region 5 and thus causing the first pn junction 6 to become forward-biassed. This forward-biassing of the first pn junction 6 causes holes to be injected into the second region 5 which flow into the third regions 8 to form, effectively, a base current for the npn transistor formed by the second, third and fourth regions 5,8,9. The turning-on of this transistor initiates triggering or latching of the thyristor so that the device is now switched on.

Once in the latched state, the thyristor may be turned-off by applying a negative gate voltage -Ve to the gate electrode G causing a p conductivity type inversion channel to be formed in a conduction channel area 90 of the fourth region 9 adjacent the trench 16. This has the effect of preventing or at least inhibiting the flow of electrons from the sixth region 13 to the fourth (cathode) region 9 thus starving the thyristor of electrons and so initiating turn-off of the thyristor. In addition, the p conductivity channel thus formed in the conduction channel area 90 of the fourth (cathode) region 9 between the third and fifth region 8 and 11 provides a conductive path for the extraction of holes via the cathode metallisation 20 to which the fifth region 11 is shorted.

The lateral extent of the sixth region 13 can be made very small so that the path for holes beneath the sixth region to the cathode metallisation and so the possibility of the pn junction 14 becoming sufficiently forward biassed to initiate transistor action is insignificant. The sixth region 13 could be formed as several discrete subsidiary regions so that when viewed in plan, that is looking down on the major surface 3, the sixth region is formed by separate islands or fingers spaced along and adjoining the edges of the trench. Although it has been assumed above that the gate electrode G is continuous, where as described above the device has a cellular structure, the cells at the periphery of the device may have a gate electrode contact which is separate from that of the central cells which may enable better control of the turn off of the device by allowing the turn-off of the central cells to be controlled independently of the peripheral cells.

Figure 2 is a cross-sectional similar to Figure 1 of a second embodiment of a device in accordance with the invention. The device shown in Figure 2 differs from that shown in Figure 1 in that a VMOS type MOS gate 160,170,180 rather than a trenchfet type MOS gate is provided and in that a separate electrical contact 20 is provided for the fifth region 11 by definition in conventional manner of an insulating region 22 of, for example silicon dioxide, on the major surface 3 and by appropriate conventional patterning of the subsequently deposited cathode metallisation 20. This has the advantage that the fifth region can, at the expense of having four terminals, be biassed independently of the sixth region 13 and so further assists in avoiding the possibility of the pn junction 14 becoming sufficiently forward-biassed to initiate transistor action when attempting to turn-off the device. In all other respects the thyristor shown in Figure 2 operates in the same manner as that shown in Figure 1 although of course holes extracted during turn-off are extracted via the further electrode 22 provided by the metallisation 21 rather than via the cathode C metallisation 20. Of course the device shown in Figure 1 may similarly be provided with a separate electrical contact for the fifth region by appropriate patterning of the cathode metallisation 20. The device shown in Figure 2 may be manufactured using conventional VMOS technology and may have a cellular structure similar to that of the device shown in Figure 1.

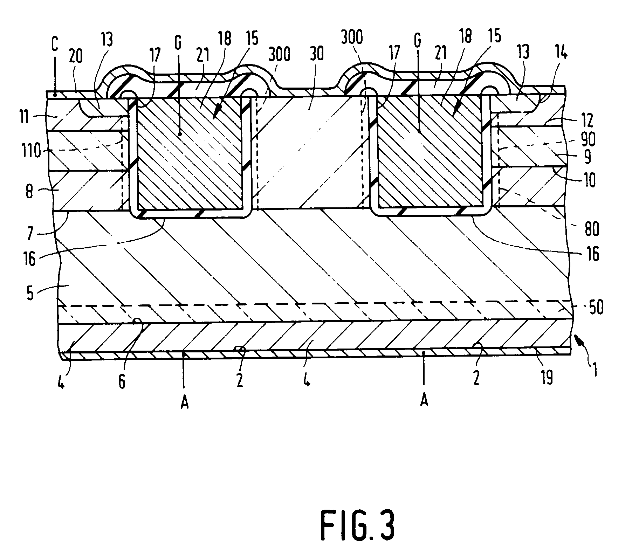

Figure 3 illustrates a modified version of a device in accordance with the invention. As mentioned above, generally a device in accordance with the invention may have a cellular structure with an array or pattern of sixth region 13 and a grid-like, when viewed looking down on the surface, insulated gate 15 to define a number of parallel-connected MOSTs provided by the fourth, fifth and sixth regions 9,11 and 13 and the insulated gate 15.

In the example shown in Figure 3 an area 30 of the semiconductor body 1 bounded by the trench or groove 16 of the insulated gate structure is in the form of a region of the one conductivity type, p conductivity type in this example, which extends from the second region 5 to the surface at which the metallisation 20 is provided to define the cathode contact C. Thus, in the region of the area 30 the device defines a three layer, pnp in this example, structure.

A number of these regions 30 or cells of the one conductivity type may be provided in the cellular structure of the device, for example alternate cells may be formed using the regions 30, by diffusion of an appropriate dopant, such as boron in this example, through a suitable mask after completion of any epitaxial growth of layers.

The device shown in Figure 3 operates in a similar manner to those shown in Figures 1 and 2 except that during turn-on with an appropriate positive gate voltage +Ve applied to the gate electrode G, in addition to the n conductivity inversion channels in the conduction channel areas 110 and 80, an n conductivity inversion channel is induced in a conduction channel area 300 defined by the region 30 adjacent the insulated gate 15.

During turn-off of the device shown in Figure 3, in addition to the p conductivity type inversion channel formed in the conduction channel area 90 inhibiting the flow of electrons, the p conductivity type region 30 provides a path to allow holes to be extracted from the device. The structure shown in Figure 3 enables an increase in the speed of turn-off and by diverting the hole current flow should also increase the maximum controllable current. The provision of the p conductivity type region 30 will increase the on-resistance of the device. However, it should be possible to optimise the device structure for the desired operating characteristics by adjusting the ratio of p conductivity type cells or regions 30 to MOST cells 9,11,13 and so adjusting the trade-off between turn-off speed and on-resistance.

Although in the examples described above, the device is a vertical device, that is a device with the main current path between the two opposed major surfaces 2 and 3 of the semiconductor body 1, this need not necessarily be the case and the present invention may be applied to lateral devices, that is devices with current flow in a direction along the major surfaces. In addition, although the devices described use a grooved technology to define the insulated gate structure, it may be possible, with appropriate geometry adjustment, to apply the present invention to a planar technology where the insulated gate 15 is formed on the one major surface 3 and the regions 8,9 and 11 are like the region 13 formed as planar regions by introducing, using appropriate maskings, impurities into the surface of the second region 5. With such a planar geometry, the channel length at the surface of the device would necessarily be rather long.

Moreover, although the insulated gates G, 15 are described above as being contiguous or integral, they may be discrete and may be separately operable. For example,the gates G, 15 may be formed by having separate grooves for the insulated gate G and for the insulated gate 15 or by appropriate patterning where a planar technology is used.

It will of course be appreciated that the semiconductor conductivity types given above can be reversed to form a pnpn thyristor and that the present invention may be applied to semiconductor materials other than silicon, for example germanium or III-V materials such as gallium arsenide or to devices involving heterojunction structures. Thus, for example, the sixth region 13 could be formed by depositing a wider bandgap material such as silicon carbide where the device is a silicon device on the fifth region 11 and then, using apporpriate masking and etching technology, defining the sixth region 13 as a mesa structure on the fifth region 11.

It has been stated above that the drawings illustrate examples of embodiments of the invention and, in order to avoid any misunderstanding, it is hereby further stated that, in the following claims, where technical features mentioned in any claim are followed by reference signs relating to features in the drawings and placed between parentheses, these reference signs have been included in accordance with Rule 29(7) EPC for the sole purpose of facilitating comprehension of the claim, by reference to an example.

## Claims

1. A semiconductor device comprising a semiconductor body (1) having formed therein a thyristor having first and second main electrodes (A and C), a first region (4) of one conductivity type provided with the first main electrode (A), a second region (5) of the opposite conductivity type forming a first pn junction (6) with the first region (4), a third region (8) of the one conductivity type forming a second pn junction (7) with the second region (5), a fourth region (9) of the opposite conductivity type forming a third pn junction (10) with the third region (8), the third region (8) being provided with a insulated gate electrode (G) overlying a first conduction channel area (80), a fifth region (11) of the one conductivity type forming a fourth pn junction (12) with the fourth region (9), and a sixth region (13) of the opposite conductivity type in electrical connection with the second main electrode (C) forming a fifth pn junction (14) with the fifth region (11), characterised in that the sixth region (13) is separated from the fourth region (9) by the fifth region (11), the fifth region (11) is coupled to an electrode (21, C) and in that the insulated gate (G, 15) overlies adjacent first (80), second (90) and third (110) conduction channel areas of the third (8), fourth (9) and fifth (11) regions, respectively, the adjacent first (80), second (90) and third (110) conduction channels areas providing an opposite conductivity type charge carrier conductive path between the sixth (13) and second (5) regions for initiating thyristor action to turn on the device when a voltage of a given polarity is applied to the insulated gate electrode (G, 15) and a one conductivity type charge carrier conductive path to the electrode (21,C) via the fifth region along which charge carriers of the one conductivity type are extracted and the flow of opposite conductivity type charge carriers is inhibited to facilitate turn-off of the device when a voltage of the opposite polarity to the given polarity is applied to the insulated gate electrode (G, 15).

2. A semiconductor device according to Claim 1, further characterised in that the insulated gate (G,15) is defined on the side walls of a groove (16,160) extending into the semiconductor body.

3. A semiconductor device according to Claim 2, further characterised in that the groove (16) is in the form of a trench having its side walls covered by an insulating layer (17) and being filled with electrically conductive material (18) forming the gate electrode.

4. A semiconductor device according to any one of the preceding claims, further characterised in that, in one or more areas of the semiconductor body, the third, fourth, fifth and sixth regions (8,9,11 and 13) are replaced by a further region (30) of the one conductivity with the insulated gate (15) overlying a conduction channel area (300) of the further region (30) so that the further region (30) defines with the first and second regions (4 and 5) a three layer structure arranged in parallel with the structure defined by the first to sixth regions (4, 5, 8, 9, 11 and 13) between the first and second main electrodes (A and C) such that the further region (30) provides a path for extraction of charge carriers of the one conductivity during turn-off of the thyristor.

5. A semiconductor device according to any one of the preceding claims, further characterised in that the first main electrode (A) is provided on one main surface (2) of the semiconductor body (1) and the second main electrode (C) is provided on the other opposed main surface of the semiconductor body (1).

6. A semiconductor device according to any one of the preceding claims, further characterised in that the fifth region (11) is electrically connected to the second main electrode (C).

7. A semiconductor device according to any one of Claims 1 to 7, further characterised in that the fifth region (11) is connected to a further separate electrode (21).

## Patentansprüche

1. Halbleiteranordnung mit einem Halbleiterkörper (1), welcher einen darin ausgebildeten Thyristor mit einer ersten und einer zweiten Hauptelektrode ( und C), eine mit der ersten Hauptelektrode (A) versehene, erste Zone (4) des einen Leitfähigkeitstypes, eine einen ersten PN-Übergang (6) mit der ersten Zone (4) bildende, zweite Zone (5) des entgegengesetzten Leitrahigkeitstypes, eine einen zweiten PN-Übergang (7) mit der zweiten Zone (5) bildende, dritte Zone (8) des einen Leitfähigkeitstypes, eine einen dritten PN-Übergang (19) mit der dritten Zone (8) bildende,vierte Zone (9) des entgegengesetzten Leitrahigkeitstypes, wobei die dritte Zone (8) mit einer einen ersten Leitungskanal (80) überdeckenden, isolierten Steuerelektrode (G) versehen ist, eine einen vierten PN-Übergang (12) mit der vierten Zone (9) bildende, fünfte Zone (11) des einen Leitrahigkeitstypes sowie eine sich in elektrischer Verbindung mit der zweiten Hauptelektrode (C) befindende, einen fünften PN-Übergang (14) mit der fünften Zone (11) bildende, sechste Zone (13) des entgegengesetzten Leitfähigkeitstypes aufweist, dadurch gekennzeichnet, daß die sechste Zone (13) von der vierten Zone (9) durch die fünfte Zone (11) getrennt, die fünfte Zone (1) mit einer Elektrode (21, C) verbunden ist, und daß die isolierte Steuerelektrode (G, 15) einen angrenzenden ersten (80), zweiten (90) und dritten Leitungskanal (110) der dritten (8), vierten (9) bzw. fünften Zone (11) überdeckt, wobei der angrenzende erste (80), zweite (90) und dritte Leitungskanal (110) eine Ladungsträgerleiterbahn des entgegengesetzten Leitfähigkeitstypes zwischen der sechsten (13) und zweiten Zone (5) vorsieht, um den Thyristorbetrieb zu starten und die Anordnung einzuschalten, sobald eine Spannung einer vorgegebenen Polarität an die isolierte Steuerelektrode (G, 15) angelegt wird, sowie eine Ladungsträgerleiterbahn des einen Leitfähigkeitstypes zu der Elektrode (21,C) über die fünfte Zone vorsieht, entlang welcher Ladungsträger des einen Leitfähigkeitstypes abgesaugt werden, und der Fluß der Ladungsträger des entgegengesetzten Leitfähigkeitstypes unterbunden wird, um ein Abschalten der Anordnung zu ermöglichen, sobald eine Spannung der umgekehrten Polarität an die isolierte Steuerelektrode (G, 15) angelegt wird.

2. Halbleiteranordnung nach Anspruch 1, weiterhin dadurch gekennzeichnet, daß die isolierte Steuerelektrode (G,15) an den Seitenwänden einer sich in den Halbleiterkörper erstreckenden Vertiefung (16,160) ausgebildet ist.

3. Halbleiteranordnung nach Anspruch 2, weiterhin dadurch gekennzeichnet, daß die Vertiefung in Form eines Grabens vorgesehen ist, wobei die Seitenwände des Grabens mit einer Isolierschicht (17) versehen und zur Ausbildung der Steuerelektrode mit elektrisch leitendem Material (18) gefüllt sind.

4. Halbleiteranordnung nach einem der vorangegeangenen Ansprüche, weiterhin dadurch gekennzeichnet, daß in einem oder mehreren Bereichen des Halbleiterkörpers die dritte, vierte, fünfte und sechste Zone (8,9,11 und 13) durch eine weitere Zone (30) des einen Leitfähigkeitstypes ersetzt, wobei die isolierte Steuerelektrode (15) einen Leitungskanal (300) der weiteren Zone (30) so überdeckt, daß die weitere Zone (30) mit der ersten und zweiten Zone (4 und 5) eine dreischichtige Struktur definiert, welche parallel zu der durch die erste bis sechste Zone (4,5,8,9,11 und 13) definierten Struktur zwischen der ersten und zweiten Hauptelektrode (A und C) so angeordnet ist, daß die weitere Zone (30) eine Bahn zum Absaugen von Ladungsträgern des einen Leitfähigkeitstypes bei Abschalten des Thyristors vorsieht.

5. Halbleiteranordnung nach einem der vorangegangenen Ansprüche, weiterhin dadurch gekennzeichnet, daß die erste Hauptelektrode (A) auf einer Hauptoberfläche (2) des Halbleiterkörpers (1) und die zweite Hauptelektrode (C) auf der anderen, entgegengesetzten Hauptoberfläche des Halbleiterkörpers (1) vorgesehen ist.

6. Halbleiteranordnung nach einem der vorangegangenen Ansprüche, weiterhin dadurch gekennzeichnet, daß die fünfte Zone (11) mit der zweiten Hauptelektrode (C) elektrisch verbunden ist.

7. Halbleiteranordnung nach einem der Ansprüche 1 bis 6, weiterhin dadurch gekennzeichnet, daß die fünfte Zone (11) mit einer weiteren, separaten Elektrode (21) verbunden ist.

## Revendications

1. Dispositif semi-conducteur comprenant un corps semi-conducteur (1) dans lequel est formé un thyristor comportant une première et une deuxième électrodes principales (A et C), une première région (4) d'un premier type de conductivité pourvue de la première électrode principale (A), une deuxième région (5) du type de conductivité opposé formant une première jonction pn (6) avec la première région (4), une troisième région (8) du premier type de conductivité formant une deuxième jonction pn (7) avec la deuxième région (5), une quatrième région (9) du type de conductivité opposé formant une troisième jonction pn (10) avec la troisième région (8), la troisième région (8) étant pourvue d'une électrode de grille isolée (G) recouvrant une première zone de canal de conduction (80), une cinquième région (11) du premier type de conductivité formant une quatrième jonction pn (12) avec la quatrième région (9), et une sixième région (13) du type de conductivité opposé en connexion électrique avec la deuxième électrode principale (C) formant une cinquième jonction pn (14) avec la cinquième région (11), caractérisé en ce que la sixième région (13) est séparée de la quatrième région (9) par la cinquième région (11), la cinquième région (11) est couplée à une électrode (21, C) et en ce que la grille isolée (G, 15) recouvre une première (80), une deuxième (90) et une troisième (110) zones de canal de conduction voisines de la troisième (8), de la quatrième (9) et de la cinquième (11) régions, respectivement, la première (80), la deuxième (90) et la troisième (110) zones de canal de conduction voisines formant un trajet conducteur de porteurs de charge du type de conductivité opposé entre la sixième (13) et la deuxième (5) régions pour amorcer l'action du thyristor afin de débloquer le dispositif lorsqu'une tension d'une polarité donnée est appliquée à l'électrode de grille isolée (G, 15), et un trajet conducteur de porteurs de charge du premier type de conductivité vers l'électrode (21, C) via la cinquième région le long duquel des porteurs de charge du premier type de conductivité sont extraits et le flux des porteurs de charge du type de conductivité opposé est empêché pour faciliter le blocage du dispositif lorsqu'une tension de la polarité opposée à la polarité donnée est appliquée à l'électrode de grille isolée (G, 15).

2. Dispositif semi-conducteur selon la revendication 1, caractérisé en outre en ce que la grille isolée (G, 15) est définie sur les parois latérales d'une rainure (16, 160) s'étendant dans le corps semi-conducteur.

3. Dispositif semi-conducteur selon la revendication 2, caractérisé en outre en ce que la rainure (16) se présente sous la forme d'une rigole dont les parois latérales sont revêtues d'une couche isolante (17) et qui est remplie de matière conductrice de l'électricité (18) formant l'électrode de grille.

4. Dispositif semi-conducteur selon l'une quelconque des revendications précédentes, caractérisé en outre en ce que, dans une ou plusieurs zones du corps semi-conducteur, la troisième, la quatrième, la cinquième et la sixième régions (8, 9, 11 et 13) sont remplacées par une autre région (30) du premier type de conductivité, la grille isolée (15) recouvrant une zone de canal de conduction (300) de l'autre région (30) de telle sorte que l'autre région (30) définisse avec la première et la deuxième régions (4 et 5) une structure à trois couches agencée en parallèle avec la structure définie par la première à la sixième régions (4, 5, 8, 9, 11 et 13) entre la première et la deuxième électrodes principales (A et C) de telle manière que l'autre région (30) offre un trajet pour l'extraction des porteurs de charge du premier type de conductivité pendant le blocage du thyristor.

5. Dispositif semi-conducteur selon l'une quelconque des revendications précédentes, caractérisé en outre en ce que la première électrode principale (A) est prévue sur une surface principale (2) du corps semi-conducteur (1) et la deuxième électrode principale (C) est prévue sur l'autre surface principale opposée du corps semi-conducteur (1).

6. Dispositif semi-conducteur selon l'une quelconque des revendications précédentes, caractérisé en outre en ce que la cinquième région (11) est connectée électriquement à la deuxième électrode principale (C).

7. Dispositif semi-conducteur selon l'une quelconque des revendications 1 à 7, caractérisé en outre en ce que la cinquième région (11) est connectée à une autre électrode séparée (21).
